# EUROPÄISCHE PATENTSCHRIFT

(11) **EP 3 671 805 B1**
(45) Veröffentlichungstag und Bekanntmachung des Hinweises auf die Patenterteilung: **13.09.2023**
(21) Anmeldenummer: 19217438.1
(22) Anmeldetag: 18.12.2019
(51) Int. Cl.: H01J 37/32, C23C 16/50

(54) **VORRICHTUNG UND VERFAHREN ZUM BESCHICHTEN UND INSBESONDERE PLASMABESCHICHTEN VON BEHÄLTNISSEN**
DEVICE AND METHOD FOR COATING AND ESPECIALLY FOR PLASMA COATING CONTAINERS
DISPOSITIF ET PROCÉDÉ DE REVÊTEMENT ET EN PARTICULIER DE REVÊTEMENT PLASMA DES RÉCIPIENTS

(30) Priorität: 18.12.2018 DE 102018132700
(43) Veröffentlichungstag der Anmeldung: 24.06.2020
(73) Patentinhaber: Krones AG, 93073 Neutraubling (DE)
(72) Erfinder: Krüger, Jochen, 93073 Neutraubling (DE); Ortner, Nadine, 93073 Neutraubling (DE)
(74) Vertreter: Hannke Bittner & Partner mbB Regensburg

(56) Entgegenhaltungen:
- EP-A1- 2 151 510
- DE-A1- 19 634 795
- DE-A1-102011 055 125
- DE-A1-102018 204 585
- DE-B4- 4 447 977
- JP-A- 2018 123 370

## Beschreibung

Die vorliegende Erfindung bezieht sich auf eine Vorrichtung und ein Verfahren zum Beschichten und insbesondere Plasmabeschichten von Behältnissen. Aus dem Stand der Technik ist es seit Langem bekannt, dass Behältnisse, insbesondere Kunststoffbehältnisse insbesondere an ihrer (Innen-)Oberfläche beschichtet werden. Auf diese Weise kann ein Diffundieren von Flüssigkeit oder Gas aus dem Inneren des Behältnisses nach außen oder auch ein Eintrag von Gasen von außen in das Produkt verhindert werden.

So sind beispielsweise Beschichtungen mit Siliziumoxid bekannt. Zu diesem Zweck können beispielsweise eine oder zwei Elektroden in das Innere des Behältnisses eingeführt werden und mit Spannungspulsen beaufschlagt werden. Allgemein werden für die Beschichtung von Oberflächen mit zum Beispiel Siliziumoxid in der Regel Plasmaverfahren (PECVD = plasma-enhanced chemical vapor deposition) angewandt. Dabei wird ein siliziumhaltiger Precursor (z.B. HMDSO, HMDSM, TEOS oder andere Si-haltige Verbindungen) verdampft und zusammen mit Sauerstoff in ein Vakuum eingeleitet. Die Gasmoleküle werden dann durch ein Plasma mehr oder weniger vollständig in ihre Bestandteile zerlegt und rekombinieren dann zu neuen Verbindungen, unter anderem SiOs, welches sich auf der Oberfläche abscheidet. Beispielsweise werden Kunststoffflaschen zur Verbesserung von Gasbarriereeigenschaften beschichtet, es werden jedoch auch verschiedenste Oberflächen auf diese Art und Weise beschichtet.

Die Zerlegung der Gasmoleküle erfolgt in der Regel durch Energiezufuhr, zum Beispiel durch eine intensive elektromagnetische Strahlung, wie beispielsweise Mikrowelle, Hochfrequenz oder Niederfrequenz (durch Bildung eines Plasmas). Die Rekombination des Gases und die Erzeugung einer schichtbildenden Spezies erfolgt vorrangig außerhalb des Plasmas und auch ohne die Zuführung externer Energie.

Üblicherweise werden zu diesem Zweck gepulste Plasmen eingesetzt, die ursprünglichen Gase werden in einem kurzen Energiepuls zerlegt, dann wird die Leistungszufuhr ausgeschaltet. Die Gasbruchstücke können nun neu rekombinieren. SiOs, das sich bildet, kann sich auf der Substratoberfläche als Schicht abscheiden.

Für die gewünschte Qualität der Beschichtung hängen die idealen Puls-zu-Pausezeiten von den Druckverhältnissen, der zugeführten Gasmenge und der zugeführten Energie in Form von Hochfrequenz oder von anderer elektromagnetischer Strahlung ab. Die Pulslänge und Pulsleistung sollte daher so gewählt sein, dass die vorhandenen Precursormoleküle den gewünschten Dissoziationsgrad erreichen. Längere Pulse oder extrem hohe Pulsleistungen bringen keinen Vorteil, wenn bereits alle Gasmoleküle dissoziiert sind (Sättigung). Daher werden die Pulse möglichst kurz gewählt und weisen eine ausreichend hohe Leistung auf.

Die ideale Pulslänge hängt stark von der vorhandenen Geometrie, dem Prozessdruck sowie auch der zugeführten Gasmenge ab. Besonders bevorzugt soll nach dem Plasmapuls alles abreagiert sein, die "Abgase" abtransportiert sein und die Umgebung der Oberfläche mit einem frischen Precursorgasgemisch aufgefüllt sein.

Längere Pausenzeiten sind unvorteilhaft, da dann unverbrauchtes Gas unnötig abgepumpt wird und sich die Beschichtungszeit unnötig verlängert. Zu kurze Pausenzeiten bewirken, dass die Konzentration des Precursors noch zu gering ist und dass rekombinierte Moleküle erneut dissoziiert werden.

So ist es beispielsweise möglich, für die Beschichtung von 0,25 I-Flaschen bei einem Prozessdruck von etwa 0,6 mbar und einem Gasfluss von ca. 300 sccm (Standardkubikzentimeter pro Minute), das komplette Volumen des Behältnisses in ca. 30 ms einmal auszutauschen. Pausenzeiten werden daher in dieser Größenordnung gewählt. Für die Pulse werden wie erwähnt möglichst kurze Pulse mit hoher Leistung gewählt. Besonders bevorzugt werden auch im Rahmen der unten genauer beschriebenen Erfindungen Pulslängen von ca. 5 bis 10 ms bei 0,8 bis 1,6 kW Pulsleistung verwendet.

Allerdings ist die hier beschriebene Technologie auch beispielsweise aufgrund der verwendeten Netzgeräte sehr kostenintensiv. Bekannte Vorrichtungen zum Beschichten von Behältnissen sind in EP 2 151 510 A1, JP 2018 123370 A, und DE 196 34 795 A1 beschrieben. In DE 10 2011 055125 A1 ist eine Vorrichtung zum Beschichten von Werkstücken angeordnet in verschiedenen Kammern beschrieben. DE 44 47 977 B4 beschreibt eine Vorrichtung für eine Vakuum-Plasmabehandlung, die eine Vielzahl von als Stapel übereinander angeordneten Plasmakammern aufweist, die sich jeweils einen gemeinsamen Vakuumraumbereich teilen.

Der vorliegenden Erfindung liegt daher die Aufgabe zugrunde, die Kosten für derartige Vorrichtungen und auch für deren Betrieb zu verringern. Dies wird erfindungsgemäß durch die Gegenstände der unabhängigen Patentansprüche erreicht.

Vorteilhafte Ausführungsformen und Weiterbildungen sind Gegenstand der Unteransprüche. Eine erfindungsgemäße Vorrichtung zum Beschichten von Objekten und insbesondere von Behältnissen weist wenigstens eine erste und eine zweite Beschichtungsstation auf, wobei diese Beschichtungsstationen jeweils wenigstens eine erste Beschichtungselektrode und eine zweite Beschichtungselektrode aufweisen, sowie eine Versorgungseinrichtung zur elektrischen Versorgung jeweils wenigstens einer der Beschichtungselektroden d.h. insbesondere wenigstens einer der beiden Beschichtungselektroden jeder der Beschichtungsstati-onen.

Erfindungsgemäß weist die Versorgungseinrichtung eine Hochfrequenzgeneratoreinrichtung zur Erzeugung einer Wechselspannung und/oder von Spannungspulsen auf sowie eine Wechselspannungsverteileinrichtung, welche diese Wechselspannung auf jeweils wenigstens eine Elektrode der ersten Beschichtungsstation und der zweiten Beschichtungsstation verteilt. Dabei ist die Wechselspannungsverteilungseinrichtung dazu geeignet und bestimmt, die Wechselspannungen und/oder die Spannungspulse zeitlich versetzt auf die Elektroden zu verteilen und insbesondere auf die Elektroden wenigstens zweier verschiedener und/oder der wenigstens zwei Beschichtungsstationen zu verteilen. Auf diese Weise sind insbesondere zwei Elektroden zweier Beschichtungsstationen zeitlich versetzt mit den Spannungspulsen versorgbar. Auf diese Weise werden bevorzugt unterschiedliche Beschichtungsstationen bzw. deren Elektroden zeitlich versetzt mit Spannungspulsen versorgt.

Unter einer Wechselspannung wird im Folgenden eine sich zumindest zeitlich wenigstens zeitweise ändernde Spannung verstanden. Insbesondere werden auch Spannungspulse, wie sie für Plasmabeschichtungen verwendet werden, als Wechselspannungen aufgefasst.

Bei einer bevorzugten Ausführungsform ist wenigstens eine der Elektroden in das Behältnis einführbar. Insbesondere ist dabei die Elektrode über eine Mündung des Behältnisses in dieses einführbar.

Für diesen Zweck kann die Vorrichtung eine Antriebseinrichtung aufweisen, welche eine Bewegung der Elektrode und/oder eine Bewegung des Behältnisses bewirkt. Dabei ist es möglich, dass die zweite Elektrode bzw. die Gegenelektrode außerhalb des Behältnisses angeordnet ist. es wäre jedoch auch möglich, dass beide Elektroden im Prinzip bevorzugt gleichzeitig in das Behältnis eingeführt werden. Bei einer weiteren vorteilhaften Ausführungsform ist wenigstens eine Elektrode als stangenartiger Körper ausgeführt und insbesondere als Körper, der einen Querschnitt aufweist, der geringer ist als ein Mündungsquerschnitt eines Behältnisses. Es wäre jedoch auch möglich, dass die Elektrode fest in der Kammer steht und das Behältnis (insbesondere entlang der Achse über die Lanze/Elektrode geführt wird. Bevorzugt handelt es sich bei den Behältnissen um Kunststoffbehältnisse und insbesondere Behältnisse aus PET.

Vorrichtung weist eine Transporteinrichtung auf, welche die Behältnisse und/oder die Beschichtungsstationen entlang eines vorgegebenen Transportpfads transportiert. Dabei transportiert diese Transporteinrichtung die Behältnisse insbesondere auch während des Plasmabeschichtungsvorgangs. So ist es möglich, dass die wenigstens eine Elektrode in das Behältnis eingeführt wird, während dieses Behältnis auf dem vorgegebenen Transportpfad transportiert wird.

Besonders bevorzugt weist die Vorrichtung einen Träger auf, an dem eine Vielzahl von Beschichtungsstationen angeordnet ist. Besonders bevorzugt handelt es sich hierbei um einen drehbaren Träger bzw. um ein Trägerrad, an dem diese mehreren Beschichtungsstationen vorgesehen bzw. angeordnet sind.

Alternativ sind die Beschichtungsstationen stationär angeordnet. So wäre es beispielsweise und bevorzugt möglich, dass die Beschichtungsstation(en) fest im Raum angeordnet sind und die Behältnisse zu einer Plasmakammer dieser Beschichtungsstation (und nach der Beschichtung auch wieder von dieser weg) transportiert werden. Bei einer bevorzugten Ausführungsform ist daher wenigstens einen und ist bevorzugt eine Vielzahl von Beschichtungsstationen stationär angeordnet und die Behältnisse werden diesen zugeführt.

Besonders bevorzugt weist die Vorrichtung wenigstens drei, bevorzugt wenigstens vier, besonders bevorzugt wenigstens fünf Beschichtungsstationen auf.

Wie oben erwähnt, sind die oben beschriebenen Netzgeräte kostspielig. Während im Stand der Technik üblicherweise für jede Plasmastation ein einzelnes Netzgerät benötigt wird, wird im Rahmen der Erfindung vorgeschlagen, ein Netzgerät für mehrere Stationen zu verwenden. Im Stand der Technik sind diese Netzgeräte nur für ca. 5 bis 10 ms aktiviert und danach für ca. 30 ms in einem Pausenzustand. Hardwaretechnisch werden im Stand der Technik diese Netzgeräte also mit einer Auslastung von weniger als 25 % betrieben und damit in einer ineffizienten Weise. In Verbindung mit der Erfindung ist eine effizientere Auslastung der Netzgeräte möglich.

Auch ist es im Stand der Technik nicht ohne weiteres möglich, mehrere Plasmastationen gleichzeitig mit einem Netzgerät zu betreiben, da sonst die Pulsleistung in Summe noch höher sein müsste, was den Preis noch weiter in die Höhe treibt.

Weiterhin würden sich die verschiedenen Plasmastationen untereinander beeinflussen und eine gleichmäßige Verteilung eins HF-Pulses auf mehrere Plasmakammern wäre kaum möglich.

Falls nämlich im Stand der Technik eine Station irgendein Problem hat, im Druck, in der Gasmenge, eine verzögerte Plasmazündung und dergleichen, wird sich das auch auf die benachbarten Stationen auswirken.

Durch die erfindungsgemäß vorgeschlagene Verteilung der Pulse, beispielsweise mittels eines unten genauer beschriebenen Multiplexers kann auch diese Abhängigkeit aufgehoben werden, das heißt die einzelnen Stationen sehen nichts voneinander.

Es wird daher vorgeschlagen, dass mehrere Plasmastationen bzw. Beschichtungsstationen gleichzeitig und unabhängig voneinander mit Plasmapulsen aus einem Generator versorgt werden, und einzelne, kurz aufeinanderfolgende Pulse nur einzelnen Stationen zugeordnet werden.

Bevorzugt handelt es sich bei der Wechselspannungsverteilungseinrichtung um einen Multiplexer. Unter einem Multiplexer versteht man eine Selektionsschaltung in der analogen und digitalen Elektronik, mit der aus einer Anzahl von Eingangssignalen eines ausgewählt und an den Ausgang durchgeschaltet werden kann. Damit sind Multiplexer vergleichbar mit Drehschaltern, die nicht von Hand, sondern mit elektronischen Signalen gestellt werden. Dabei sind bevorzugt integrierte Halbleiterschaltungen vorhanden, welche diese besagten elektrischen Verbindungen schalten.

Bevorzugt schlägt also die Erfindung vor, einen Multiplexer einzusetzen, der die einzelnen Hochfrequenzpulse nach einem Muster und insbesondere einem vorgegebenen und einheitlichen Muster auf die einzelnen Plasmastationen verteilt.

Besonders bevorzugt werden die Pulse derart verteilt, dass zu jeder Zeit nur maximal ein einziges Plasma aktiv ist, wobei bevorzugt die einzelnen Beschichtungsstationen bzw. Plasmastationen zeitlich versetzt zünden können, beispielsweise zeitlich versetzt um einige Millisekunden.

Damit können im Ergebnis so viele Beschichtungsstationen gemeinsam an einem Generator betrieben werden, wie Pulslängen in eine gesamte Zykluszeit passen.

Auf diese Weise kann sowohl eine Platz- als auch eine Kosteneinsparung erreicht werden. Auch verringert sich die Komplexität in der Ansteuerung. Daneben kann auch eine höhere Effizienz in der Auslastung einzelner Generatoren erreicht werden.

In einer bevorzugten Ausführungsform ist ein Hochfrequenz-Generator vorgesehen, mittels welchem ein Plasmapulsen erzeugbar ist, wobei dessen eingekoppelbare Leistung auf Basis eines Messwerts der reflektierten Leistung anpassbar ist. Dies könnte beispielsweise durch eine Anpassung der eingekoppelten Leistung oder einer Impedanzanpassung erfolgen. Dadurch kann erreicht werden, dass der Soll-Wert der eingekoppelten Leistung erreicht wird.

In einer Ausführungsform ist vorgesehen, dass die eingekoppelbare Leistung jedes einzelnen Plasmapulses individuell auf Basis eines Messwertes eines Testpulses einregelbar ist. Dazu ist vorgesehen, dass jedem Plasmapuls ein Vor-Puls mit geringerer Leistung vorangeht und die Leistung des Plasmapulses auf Basis eines Messwerts der reflektierten Leistung auf einen individuellen Sollwert anpassbar ist. Dies hat den Vorteil, dass jedes Behältnis unabhängig von dessen Form oder Materialzusammensetzung jeweils mit der benötigten Plasmaenergie beaufschlagt wird. Diese Ausführungsform ist insbesondere dann bevorzugt, wenn eine große Anzahl individuell verschiedener Behältnisse beschichtet werden soll.

Alternativ dazu hat sich eine andere Ausführungsform als besonders vorteilhaft erwiesen. Bei dieser ist ebenfalls ein Hochfrequenz-Generator vorgesehen, mittels welchem ein Plasmapulsen erzeugbar ist, wobei dessen eingekoppelbare Leistung auf Basis eines Messwerts der reflektierten Leistung anpassbar ist. Anders als oben beschrieben erfolgt die Anpassung der eingekoppelbaren Leistung Plasmapulses auf Basis eines Messwertes, bevorzugt mehrerer Messwerte eines oder bevorzugt mehrerer vorangegangener Plasmabeschichtungen. Dies hat den Vorteil, dass nicht jedem Plasmapuls ein Vor-Puls mit geringerer Leistung vorangestellt werden muss. Vor-Pulse haben nämlich den Nachteil, dass aufgrund der geringeren bereitgestellten Energie Beschichtungsreaktionen anlaufen können, jedoch die vorgesehenen chemischen Reaktionen nicht vollständig ablaufen. Dies kann zu unerwünschten Zwischenprodukten, einem notwendigen höheren Bedarf an Reaktanten und/oder einer verschlechterten Barriereleistung des abgeschiedenen Materials führen. Ein weiterer wichtiger Vorteil besteht in der Beschleunigung der Verfahrensführung, da für den Vor-Puls, die Messung der reflektierten Energie und die Einstellung der eingekoppelbare Leistung auf Basis dieses Messwerts eine Zeit von einigen Millisekunden benötigt wird. Diese Intervalle summieren sich im oben vorgeschlagenen Verfahren, bei welchem die Plasmabeschichtung in mehreren Stationen erfolgt, zu Gesamtzeiten, die eine signifikante Verlangsamung des Beschichtungsprozessen bewirken. Dies ist insbesondere bei Hochdurchsatzprozessen wie der Behältnisbehandlung nachteilig.

Vorzugsweise ist eine Steuereinrichtung mit einer Speichereinrichtung vorgesehen, welche einen Abgleich eines vorgegebenen SOLL-Werts für den nächsten Beschichtungsprozesses mit mindestens einem Messwert eines vorangegangenen Beschichtungsprozesses vornimmt. In einer bevorzugten Ausführungsform ist mindestens ein Messwert aus einer Gruppe ausgewählt, welche eine reflektierte Leistung, eine eingespeiste Leistung, eine Differenz einer eingespeisten und einer reflektierten Leistung, die ins Plasma eingekoppelte Leistung, eine optische Emission des Plasmas, einen Gas-Volumenstrom, eine Gaszusammensetzung (beispielsweise im Behältnis, im Zuführstrom und/oder im Abgasstrom), eine Temperatur der Gaslanze und eine Temperatur einer Behältnisoberfläche einzeln oder in Kombination umfasst. Diese Werte haben sich als besonders geeignet erwiesen, um die benötigte Leistung für einen zukünftigen Plasmapuls besonders zutreffend vorausberechnen zu können.

In einer bevorzugten Ausführungsform werden mehrere der Parameter aus der oben genannten Gruppe ermittelt und deren Einfluss auf die Berechnung der benötigten Leistung für einen zukünftigen Plasmapuls mit einem individuellen Faktor gewichtet. Somit wird zur Berechnung der Leistung einem, mehreren oder allen der oben genannten Parameter ein individueller Faktor zugeordnet. Dies ermöglicht eine einfache Anpassung der Berechnung auf Basis von Erfahrungswerten aus vorangegangenen Berechnungen.

In einer weiteren bevorzugten Ausführungsform ist eine Bewertungseinrichtung vorgesehen, welche den Faktor ermittelt, mit welchem ein Parameter in die Berechnung zur Ermittlung einer einkoppelbaren Leistung einfließt. Diese Bewertungseinrichtung nutzt bevorzugt einen Vergleich von Parametern vergangener Messungen zur Ermittlung eines Faktors für zukünftige Beschichtungsprozesse. Insbesondere ist bevorzugt, dass der/die von der Bewertungseinrichtung ermittelte/n Faktor/en dynamisch variabel ist/sind. Es ist besonders bevorzugt, dass der/die ermittelte/n Faktor/en nach einer vorgegebenen Anzahl von Beschichtungsprozessen neu ermittelt werden. Diesbezüglich ist es denkbar, dass ältere Messwerte eines Parameters weniger stark bei der Ermittlung eines Faktors berücksichtigt werden. Dadurch kann gewährleistet werden, dass die Bewertungseinrichtung zumindest in vorgegebenen Intervallen einen Faktor neu ermittelt und gegebenenfalls anpasst.

Insbesondere ist bevorzugt, dass die Bewertungseinrichtung ein KI-System umfasst. Dies erlaubt, dass die Bewertungseinrichtung beispielsweise Muster erkennt und den/die Faktor/en entsprechend anpasst. Eine Mustererkennung erlaubt es, eine Vorhersage abzuleiten, wie sich ein kommender Einzelpuls, eine kommende Pulsfolge und/oder der weitere Prozess verhalten wird. Unter Berücksichtigung dieser Vorhersage kann der/die Faktor/en angepasst werden.

Vorzugsweise ist eine Validierungseinrichtung vorgesehen, die die IST- und SOLL-Werte eines Pulses und/oder Beschichtungsprozesses vergleicht. Ein solcher Vergleich kann beispielsweise zum Schutz des Systems genutzt werden. Ist beispielsweise eine eingespeiste Leistung so hoch, dass deren reflektierte Leistung sehr nahe an der Leistungsgrenze (beispielsweise 10 % unterhalb der Leistungs-Obergrenze) des Generators liegt, könnte eine Zwangsbeschränkung der Leistung erfolgen.

Bevorzugt ist die Validierungseinrichtung dazu geeignet, zu überprüfen ob eine Veränderung des Faktors oder der Faktoren eine Verbesserung des Prozesses stattgefunden hat. Beispielsweise könnte zur Validierung ein Beschichtungsergebnis berücksichtigt werden. Vorzugsweise ist ein Korridor definiert, innerhalb welchem sich für die Validierung herangezogene Parameter bewegen müssen. Dadurch kann gewährleitet werden, dass ein Prozess nicht dauerhaft verschlechtert wird (beispielsweise durch einen falsch laufenden Prozess, einen Abbruch vor Prozessbeginn oder einen Abbruch während des Prozesses). Somit kann bei Erreichen oder Annäherung an eine Korridorgrenze frühzeitig verhindert werden, dass der Beschichtungsprozess zu einem mangelhaften Produkt führt. Ein System mit einer solchen Validierungseinrichtung erkennt vor erreichen unerlaubter Werte außerhalb des Korridors, dass zumindest ein Parameter außerhalb des zulässigen Bereichs liegt. Es kann dann eine Gegensteuerung veranlassen. Insbesondere in Kombination mit dem Ki-System und/oder im System hinterlegter Daten vorangegangener Messungen kann eine Anpassung mindestens eines Faktors erfolgen, um den Prozess innerhalb des definierten Korridors zu halten oder ihn wieder in den definierten Korridor zu führen.

In einer bevorzugten Ausführungsform sind von der Bewertungseinrichtung mehrere Messwerte desselben Parameters innerhalb eines einzigen Pulsverlaufs berücksichtigbar. Dies ist insbesondere deshalb vorteilhaft, da sich einzelne Parameter (beispielsweise die Menge an Frischgas und/oder das Edukt/e-Produkt/e-Verhältnis der während der Beschichtung ablaufenden chemischen Prozesse (beispielsweise im Gasvolumen)) während eines einzelnen Pulses ändern können. Einige Parameter werden durch das Plasma selbst beeinflusst. Dies kann die Impedanz des Plasmas verändern. Die Bewertungseinrichtung kann bei der Berücksichtigung mehrere Messwerte eines einzelnen Parameters innerhalb eines einzigen Pulsverlaufs den oder die Faktoren so anpassen, dass die eingekoppelte Leistung dieser Veränderung des/der berücksichtigten Parameter/s besonders vorteilhaft entgegenwirkt oder diese Veränderung unterstützt. Insbesondere ist vorteilhaft, dass ein KI-System diese Parameter während eines Pulses berücksichtigt und lernt, wie sie die eingekoppelte Leistung optimal bereitstellen kann.

Bei einer weiteren vorteilhaften Ausführungsform weist die Vorrichtung eine Medienzuführeinrichtung auf, welche dazu geeignet und bestimmt ist, dem Behältnis und/ oder den Behältnissen ein fließfähiges und insbesondere gasförmiges Medium zuzuführen. Insbesondere handelt es sich dabei um ein gasförmiges Medium, welches letztlich zur Beschichtung der Innenoberfläche dient. Besonders bevorzugt kann zur Beschichtung ein Gas bzw. ein Medium verwendet werden, welches wenigstens die Elemente Silizium (Sl) und/oder Sauerstoff (O₂) aufweist. So könnte beispielsweise SlO₂ abgeschieden werden.

Bei einer weiteren vorteilhaften Ausführungsform gibt die Hochfrequenzgeneratoreinrichtung die Spannung in Form von Spannungspulsen aus. Besonders bevorzugt handelt es sich hierbei um Rechteckspulse, die wie oben erwähnt seitlich versetzt an die einzelnen Beschichtungsstationen abgegeben werden.

Wie oben erwähnt, kann die Hochfrequenzgeneratoreinrichtung die Spannung auch in Form einer Kombination mehrerer Spannungspulse ausgeben. Besonders bevorzugt handelt es sich hierbei um mehrere Rechteckspulse, beispielsweise einem Vor-Puls mit geringerer Leistung und einem Hauptpuls (Plasmapuls), die wie oben erwähnt zeitlich versetzt aufeinander folgen können.

Bei einer weiteren vorteilhaften Ausführungsform verteilt die Wechselspannungsverteileinrichtung die von der Hochfrequenzgeneratoreinrichtung ausgegebenen Impulse jeweils vollständig auf die einzelnen Elektroden. Dies bedeutet, dass jeder Puls bevorzugt genau einer Beschichtungsstation zugeordnet wird. Bevorzugt gibt es auch keine Überlappung zwischen den Pulsen, die an die einzelnen Beschichtungsstationen gehen.

Damit erfolgt kein Umschalten der Multiplexereinrichtung während eines Pulses, sondern der Puls wird vollständig an eine bestimmte Beschichtungsstation abgegeben. Besonders bevorzugt handelt es sich, wie oben erwähnt, um Rechteckspulse.

Bei einer weiteren bevorzugten Ausführungsform ist die Wechselspannungsverteileinrichtung auf die Generatoreinrichtung getriggert.

Besonders bevorzugt ist ein zeitlicher Abstand zwischen zwei Pulsen kürzer als die zeitliche Dauer des jeweiligen Pulses.

Die vorliegende Erfindung ist weiterhin auf ein Verfahren zum Beschichten von Objekten und insbesondere von Behältnissen gerichtet, wobei wenigstens eine erste und eine zweite Beschichtungsstation verwendet wird. Dabei weisen diese Beschichtungsstationen jeweils wenigstens eine erste Beschichtungselektrode und eine zweite Beschichtungselektrode auf und mit einer Versorgungseinrichtung wird wenigstens eine der Beschichtungselektroden mit elektrischer Energie versorgt.

Erfindungsgemäß stellt eine Versorgungseinrichtung mittels einer Hochfrequenzgeneratoreinrichtung eine Wechselspannung und insbesondere Spannungspulse zur Verfügung und eine Wechselspannungverteileinrichtung verteilt diese Wechselspannung und/oder diese Spannungspulse auf wenigstens eine Elektrode der ersten Beschichtungsstation und wenigstens eine Elektrode der zweiten Beschichtungsstation. Dabei verteilt die Wechselspannungsverteileinrichtung die Wechselspannungen zeitlich versetzt auf die jeweiligen Elektroden und/oder die Beschichtungsstationen. Bevorzugt werden die Wechselspannung zeitlich versetzt auf die jeweiligen Elektroden der beiden Beschichtungsstationen verteilt.

Es wird daher auch verfahrensseitig vorgeschlagen, dass die jeweiligen Spannungspulse, die zur Erzeugung des Plasmas nötig sind, auf die einzelnen Beschichtungsstationen aufgeteilt werden. Damit beeinflussen sich die einzelnen Beschichtungsstationen nicht gegenseitig, sodass etwa auftretende Fehler einzelner Beschichtungsportionen nicht zu einem Ausfall auch bei den anderen Beschichtungsstationen führen.

Bei einem weiteren bevorzugten Verfahren steuert eine Steuerungseinrichtung die Hochfrequenzgeneratoreinrichtung derart, dass Spannungspulse in vorgegebenen Zeitabständen abgegeben werden. Besonders bevorzugt ist dabei die Länge eines Spannungspulses länger als der zeitliche Abstand zweier Pulse.

Durch eine geeignete Wahl der jeweiligen Pausenzeiten zwischen den einzelnen Spannungspulsen können so möglichst viele Beschichtungsstationen mittels einer Generatoreinrichtung betrieben werden.

Bevorzugt weisen die Pulse eine Pulslänge auf, die größer ist als 2 ms, bevorzugt größer als 3 ms, bevorzugt größer als 4 ms und besonders bevorzugt größer als 5 ms.

Die Spannungspulse weisen eine zeitliche Länge auf, die kleiner ist als 40 ms, bevorzugt kleiner als 30 ms, bevorzugt kleiner als 20 ms, bevorzugt kleiner als 15 ms und bevorzugt kleiner als 10 ms. Bei einem weiteren bevorzugten Verfahren ist eine Pulsleistung der Spannungspulse größer als 0,4 kW, bevorzugt größer als 0,5 kW, bevorzugt größer als 0,6 kW und bevorzugt größer als 0,7 kW.

Bei einem weiteren bevorzugten Verfahren ist eine Pulsleistung der besagten Pulse kleiner als 4 kW, bevorzugt kleiner als 3 kW, bevorzugt kleiner als 2 kW und besonders bevorzugt kleiner als 1,7 kW.

Bevorzugt sind die Pausenzeiten zwischen zwei Pulsen geringer als 20 ms, bevorzugt geringer als 15 ms, bevorzugt geringer als 10 ms, bevorzugt geringer als 7 ms, bevorzugt geringer als 5 ms und besonders bevorzugt geringer als 3 ms.

Allerdings hängen die Pausenzeiten zwischen zwei Pulsen, welche die Hochfrequenzgeneratoreinrichtung abgibt auch von der Anzahl der zu versorgenden Stationen ab.

So wäre es beispielsweise möglich, dass für jede einzelne Beschichtungsstation die Puls-Pausendauer bei 30 ms liegt und die Pulsdauer bei 8 ms. Die Pulse, die der Generator ausgibt und dann auf die einzelnen Stationen verteilt, liegen idealerweise zeitlich so weit auseinander, dass sie gleichmäßig verteilt sind.

Wenn z.B. nur zwei Stationen beschickt werden, liegt der zweite Puls mittig in der Pause der ersten Station. Die Pulsfolge des Generators ist dann 8 ms ,an' - 11 ms ,aus' - 8 ms ,an' - 11 ms ,aus' usw. Jede Einzelstation sieht in diesem Fall 8 ms an - 30 ms ,aus'.

Bevorzugt werden die beiden Elektroden bzw. die Elektroden der beiden Beschichtungsstationen unabhängig voneinander betrieben.

Bei einem weiteren bevorzugten Verfahren gibt die Hochfrequenzgeneratoreinrichtung die Wechselspannung in Form von Spannungspulsen aus. Besonders bevorzugt handelt es sich hierbei um Rechteckspulse.

Bei einem weiteren bevorzugten Verfahren steuert eine Steuerungseinrichtung die Hochfrequenzgeneratoreinrichtung derartig, dass die Spannungspulse in vorgegebenen Zeitabständen abgegeben werden. Besonders bevorzugt werden die Spannungspulse in im Wesentlichen konstanten Zeitabständen abgegeben.

Bei einem weiteren bevorzugten Verfahren verteilt die Wechselspannungsverteileinrichtung die Spannungspulse derart, dass zu einem vorgegebenen Zeitpunkt nicht mehr als eine Beschichtungsstation mit Spannung versorgt wird.

Besonders bevorzugt werden die einzelnen Stationen in einer vorgegebenen Reihenfolge versorgt.

Weitere Vorteile und Ausführungsformen ergeben sich aus den beigefügten Zeichnungen. Darin zeigen:
- Fig. 1: eine Darstellung einer Anordnung nach dem Stand der Technik;
- Fig. 2: eine Darstellung einer erfindungsgemäßen Ausführungsform; und
- Fig. 3: eine weitere Darstellung einer erfindungsgemäßen Vorrichtung.

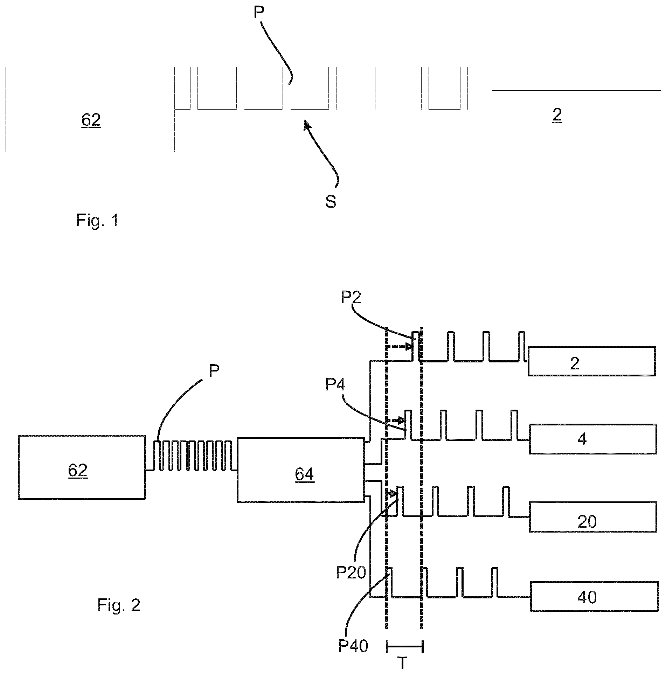

Fig. 1 zeigt eine Darstellung eine aus dem Stand der Technik bekannten Ausgestaltung. Dabei ist eine Hochfrequenz-Generatoreinrichtung 62 vorgesehen, welche Spannung P erzeugt, welche jeweils in vorgegebenen zeitlichen Abständen zueinander an eine Beschichtungsstation 2 ausgegeben werden. Dabei ist für jede Beschichtungsstation eine Hochfrequenz - Generatoreinrichtung vorgesehen.

Fig. 2 zeigt eine Darstellung einer erfindungsgemäßen Vorrichtung. Hier ist ebenfalls eine Hochfrequenz - Generatoreinrichtung 62 vorgesehen, welche Spannungspulse P ausgibt. Man erkennt jedoch, dass diese Spannungspulse in wesentlich kürzeren Abständen zueinander ausgegeben werden als bei der in Fig. 1 gezeigten Situation.

Zusätzlich ist eine Wechselspannungsverteileinrichtung, wie insbesondere ein Multiplexer 64 vorgesehen, welcher die einzelnen Pulse P in Form von zeitlich zueinander versetzten Pulsen P2, P4, P20 und P40 auf hier vier Beschichtungsstationen 2, 4, 20, 40 verteilt.

Das Bezugszeichen T kennzeichnet dabei das Intervall, in dem alle Pulse abgegeben werden. Man erkennt, dass die einzelnen Pulse P2, P4, P20 und P40 zueinander zeitlich versetzt sind.

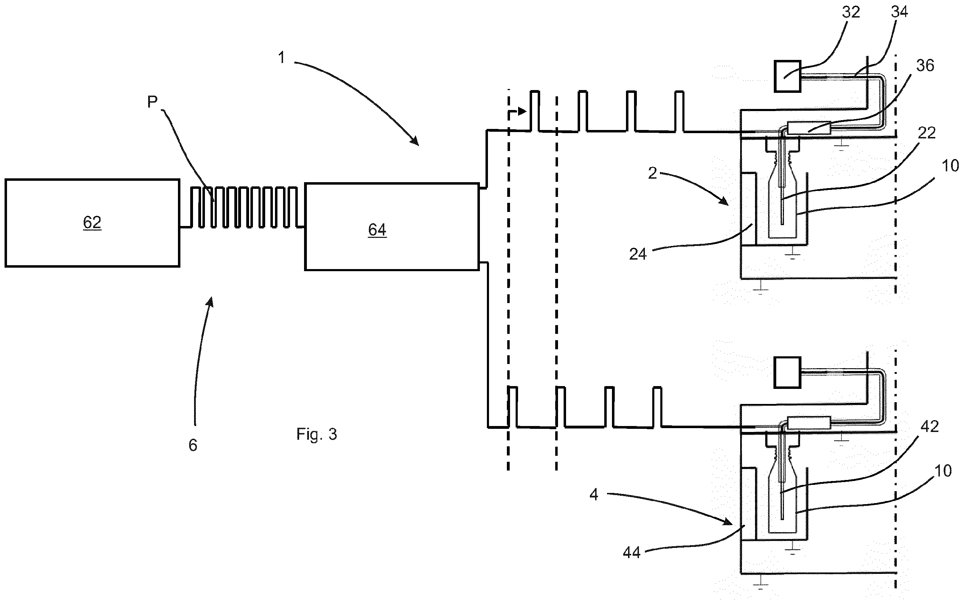

Fig. 3 zeigt eine detailliertere Darstellung einer erfindungsgemäßen Vorrichtung 1. Dabei bezieht sich das Bezugszeichen 6 auf eine Versorgungseinrichtung, welche die Hochfrequenz - Generatoreinrichtung 62 und die Wechselspannungsverteileinrichtung 64 aufweist.

Bei der hier gezeigten Ausführungsform werden die Spannungspulse auf zwei Beschichtungsstationen zeitlich versetzt aufgeteilt.

Diese Beschichtungsstationen 2, 4 weisen jeweils eine erste Elektrode 22 bzw. 42, auf, die in ein zu beschichtendes Behältnis 10 einführbar ist. Daneben wiesen die Beschichtungsstationen 2, 4 jeweils eine zweite Elektrode 24, 44 auf, welche außerhalb des Behältnisses 10 angeordnet ist. Bevorzugt sind diese zweiten Elektrode 24, 44 hier geerdet.

Das Bezugszeichen 32 kennzeichnet ein Medienreservoir, etwa ein Reservoir für ein Gasgemisch, etwa ein Gemisch aus HMDSO + O₂. Das Bezugszeichen 34 kennzeichnet eine Zuführleitung, um den Behältnissen das Medium zuzuführen und das Bezugszeichen 36 eine Steuerungseinrichtung, welche die Zuführung des Mediums in die Behältnisse 10 steuert. SiO₂ entsteht erst im Plasma in dem Behältnis, genauer gesagt zwischen zwei Plasmapulsen.

Die Anmelderin behält sich vor, sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

### Bezugszeichenliste

- 1: Vorrichtung
- 2, 4: Beschichtungsstation
- 6: Versorgungseinrichtung
- 10: Behältnis
- 22, 42: erste Elektrode
- 24, 44: zweite Elektrode
- 32: Medienreservoir
- 34: Medienleitung
- 36: Steuerungseinrichtung
- 62: Hochfrequenz - Generatoreinrichtung
- 64: Wechselspannungsverteileinrichtung, Multiplexer

- P: Spannungspuls
- P2, P4, P20, P40: aufgeteilte Spannungspulse
- T: Periode

## Patentansprüche

1. Vorrichtung zum Beschichten von Objekten (10) und insbesondere von Behältnissen (10) mit wenigstens einer ersten und einer zweiten Beschichtungsstation (2, 4), wobei diese Beschichtungsstationen (2, 4) jeweils wenigstens eine erste Beschichtungselektrode (22, 42) und eine zweite Beschichtungselektrode (24, 44) aufweisen und mit einer Versorgungseinrichtung (6) zur elektrischen Versorgung jeweils wenigstens einer der Beschichtungselektroden (22, 24),
wobei
die Versorgungseinrichtung (6) eine Hochfrequenz-Generatoreinrichtung (62) zur Erzeugung von Spannungspulsen (P, P2, P4, P20, P40) aufweist, wobei die Spannungspulse eine zeitliche Länge aufweisen, die kleiner als 40 ms ist, und eine Wechselspannungsverteileinrichtung (64) aufweist, welche diese Spannungspulse (P, P2, P4, P20, P40) auf jeweils wenigstens eine Elektrode der ersten Beschichtungsstation (2) und der zweiten Beschichtungsstation (4) verteilt, wobei die Wechselspannungsverteileinrichtung dazu geeignet und bestimmt ist, die Spannungspulse (P, P2, P4, P20, P40) zeitlich versetzt auf die Elektroden zu verteilen, wobei die Vorrichtung eine Transporteinrichtung aufweist, welche die Behältnisse und/oder die Beschichtungsstationen entlang eines vorgegebenen Transportpfads transportiert.

2. Vorrichtung (1) nach Anspruch 1,
wobei
die Wechselspannungsverteileinrichtung (64) als Multiplexer ausgebildet ist.

3. Vorrichtung (1) nach wenigstens einem der vorangegangenen Ansprüche,
wobei
die Vorrichtung (1) eine bewegbare und insbesondere drehbare Transporteinrichtung aufweist, an der die Beschichtungsstationen (2, 4) angeordnet sind.

4. Vorrichtung (1) nach wenigstens einem der vorangegangenen Ansprüche,
wobei
die Beschichtungsstationen (2, 4) stationär angeordnet sind.

5. Vorrichtung (1) nach wenigstens einem der vorangegangenen Ansprüche,
wobei
die Vorrichtung eine Medienzuführeinrichtung (32, 34, 36) aufweist, welche dazu geeignet und bestimmt ist, dem Behältnis ein fließfähiges und insbesondere gasförmiges Medium zuzuführen.

6. Vorrichtung (1) nach wenigstens einem der vorangegangenen Ansprüche,
wobei
die Hochfrequenz - Generatoreinrichtung die Spannung in Form von Spannungspulsen (P, P2, P4, P20, P40) ausgibt.

7. Vorrichtung (1) nach dem vorangegangenen Anspruch,
wobei
die Wechselspannungsverteileinrichtung die von der Hochfrequenz - Generatoreinrichtung ausgegebenen Pulse jeweils vollständig auf die einzelnen Elektroden verteilt.

8. Vorrichtung (1) nach wenigstens einem der vorangegangenen Ansprüche,
wobei
die eingekoppelbare Leistung der Hochfrequenz-Generatoreinrichtung auf Basis eines Messwerts der reflektierten Leistung anpassbar ist.

9. Vorrichtung (1) nach dem vorangegangenen Anspruch,
wobei
sie eine Steuereinrichtung mit einer Speichereinrichtung umfasst, mittels welcher ein vorgegebener SOLL-Wert für einen nächsten Beschichtungsprozess mit mindestens einem Messwert eines vorangegangenen Beschichtungsprozesses abgleichbar ist, wobei bevorzugt mindestens ein Messwert ein Messwert eines Parameters ist, der aus einer Gruppe ausgewählt ist, welche eine reflektierte Leistung, eine eingespeiste Leistung, eine Differenz einer eingespeisten und einer reflektierten Leistung, die ins Plasma eingekoppelte Leistung, eine optische Emission des Plasmas, einen Gas-Volumenstrom, eine Gaszusammensetzung, eine Temperatur der Gaslanze und eine Temperatur einer Behältnisoberfläche einzeln oder in Kombination umfasst.

10. Vorrichtung (1) nach dem vorangegangenen Anspruch,
wobei
sie eine Bewertungseinrichtung umfasst, durch welche ein Faktor ermittelbar ist, mit welchem ein Parameter in die Berechnung zur Ermittlung einer einzukoppelnden Leistung einfließt, wobei bevorzugt der Faktor dynamisch variabel ist.

11. Vorrichtung (1) nach dem vorangegangenen Anspruch,
wobei
die Bewertungseinrichtung ein KI-System zur Erkennung von Mustern und zur darauf basierenden Anpassung des Faktors umfasst.

12. Verfahren zum Beschichten von Objekten (10) und insbesondere von Behältnissen (10) mit wenigstens einer ersten und einer zweiten Beschichtungsstation (2, 4), wobei diese Beschichtungsstationen (2, 4) jeweils wenigstens eine erste Beschichtungselektrode (22, 42) und eine zweite Beschichtungselektrode (24, 44) aufweisen und wobei mit einer Versorgungseinrichtung (6) jeweils wenigstens eine der Beschichtungselektroden (22, 24) mit elektrischer Energie versorgt wird,
wobei
die Versorgungseinrichtung (6) mittels einer Hochfrequenz-Generatoreinrichtung (62) Spannungspulse (P, P2, P4, P20, P40) zur Verfügung stellt, wobei die Spannungspulse eine zeitliche Länge aufweisen, die kleiner als 40 ms ist, und eine Wechselspannungsverteileinrichtung (64) diese Spannungspulse (P, P2, P4, P20, P40) auf jeweils wenigstens eine Elektrode der ersten Beschichtungsstation (2) und wenigstens eine Elektrode der zweiten Beschichtungsstation (4) verteilt, wobei die Wechselspannungsverteileinrichtung die Spannungspulse (P, P2, P4, P20, P40) zeitlich versetzt auf die Elektroden verteilt, wobei die Vorrichtung eine Transporteinrichtung aufweist, welche die Behältnisse und/oder die Beschichtungsstationen entlang eines vorgegebenen Transportpfads transportiert.

13. Verfahren nach Anspruch 12,
wobei
die Hochfrequenz-Generatoreinrichtung (62) die Wechselspannung in Form von Spannungspulsen ausgibt.

14. Verfahren nach dem vorangegangenen Anspruch,
wobei
eine Steuerungseinrichtung die Hochfrequenz- Generatoreinrichtung (62) derart steuert, dass die Spannungspulse in vorgegebenen Zeitabständen abgegeben werden.

15. Verfahren nach wenigstens einem der vorangegangenen Ansprüche 12 - 14,
wobei
die Wechselspannungs-Verteileinrichtung die Spannungspulse derart verteilt, dass zu einem vorgegebenen Zeitpunkt nicht mehr als eine Beschichtungsstation (2, 4) mit Spannung versorgt wird.

## Claims

1. Apparatus for coating objects (10) and in particular containers (10) with at least one first and one second coating station (2, 4), wherein these coating stations (2, 4) each have at least one first coating electrode (22, 42) and one second coating electrode (24, 44), and with a supply device (6) for electrical supply of in each case at least one of the coating electrodes (22, 24),
wherein
the supply device (6) has a high-frequency generator device (62) for generating voltage pulses (P, P2, P4, P20, P40), wherein the voltage pulses have a temporal length which is less than 40 ms and an AC voltage distribution device (64) which distributes the voltage pulses (P, P2, P4, P20, P40) respectively to in each case at least one electrode of the first coating station (2) and of the second coating station (4), wherein the AC voltage distribution device is suitable and intended for distributing the voltage pulses (P, P2, P4, P20, P40) with a time delay to the electrodes, wherein the apparatus has a transport device which transports the containers and/or the coating stations along a predetermined transport path.

2. Apparatus (1) according to claim 1,
wherein
the AC voltage distribution device (64) is designed as a multiplexer.

3. Apparatus (1) according to at least one of the preceding claims,
wherein
the apparatus (1) has a movable and in particular rotatable transport device on which the coating stations (2, 4) are arranged.

4. Apparatus (1) according to at least one of the preceding claims,
wherein
the coating stations (2, 4) are arranged stationary.

5. Apparatus (1) according to at least one of the preceding claims,
wherein
the apparatus has a media feeding device (32, 34, 36) which is suitable and intended for feeding a flowable and in particular gaseous medium to the container.

6. Apparatus (1) according to at least one of the preceding claims,
wherein
the high-frequency generator outputs the voltage in the form of voltage pulses (P, P2, P4, P20, P40).

7. Apparatus (1) according to the preceding claim,
wherein
the AC voltage distribution device distributes the pulses output by the high-frequency generator device in each case completely to the individual electrodes.

8. Apparatus (1) according to at least one of the preceding claims,
wherein
the couplable power of the high-frequency generator device is adaptable on the basis of a measured value of the reflected power.

9. Apparatus (1) according to the preceding claim,
wherein
it comprises a control device with a storage device by means of which a predetermined target value for a subsequent coating process is adjustable with at least one measurement value of a preceding coating process, wherein preferably at least one measurement value is a measurement value selected from a group which comprises a reflected power, a supplied power, a difference between a supplied and a reflected power, the power coupled into the plasma, an optical emission of the plasma, a gas volumetric flow rate, a gas composition, a temperature of the gas lance and a temperature of a container surface, individually or in combination.

10. Apparatus (1) according to the preceding claim,
wherein
it comprises an evaluation device which can determine a factor with which a parameter is included in the calculation for determining a couplable power, wherein the factor is preferably dynamically variable.

11. Apparatus (1) according to the preceding claim,
wherein
the evaluation device comprises an Al system recognising patterns and, based thereon, adapting the factor.

12. Method for coating objects (10) and in particular containers (10) with at least one first and one second coating station (2, 4), wherein these coating stations (2, 4) each have at least one first coating electrode (22, 42) and one second coating electrode (24, 44), and wherein with a supply device (6) in each case at least one of the coating electrodes (22, 24) is supplied with electrical energy,
wherein
the supply device (6) provides by means of a high-frequency generator device (62) voltage pulses (P, P2, P4, P20, P40), wherein the voltage pulses have a temporal length which is less than 40 ms and an AC voltage distribution device (64) distributes the voltage pulses (P, P2, P4, P20, P40) respectively to in each case at least one electrode of the first coating station (2) and at least one electrode of the second coating station (4), wherein the AC voltage distribution device distributes the voltage pulses (P, P2, P4, P20, P40) with a time delay to the electrodes, wherein the apparatus has a transport device which transports the containers and/or the coating stations along a predetermined transport path.

13. Method according to claim 12,
wherein
the high-frequency generator (62) outputs the AC voltage in the form of voltage pulses.

14. Method according to the preceding claim,
wherein
a control device controls the high-frequency generator device (62) in such a way that the voltage pulses are emitted at predetermined time intervals.

15. Method according to at least one of the preceding claims 12-14,
wherein
the AC voltage distribution device distributes the voltage pulses in such a way that at a predetermined time no more than one coating station (2, 4) is supplied with voltage.

## Revendications

1. Dispositif pour le revêtement d'objets (10) et en particulier de récipients (10) avec au moins un premier et un deuxième poste de revêtement (2, 4), dans lequel ces postes de revêtement (2, 4) présentent respectivement au moins une première électrode de revêtement (22, 42) et une deuxième électrode de revêtement (24, 44) et avec un équipement d'alimentation (6) pour l'alimentation électrique de respectivement au moins l'une des électrodes de revêtement (22, 24),
dans lequel
l'équipement d'alimentation (6) présente un équipement de générateur haute fréquence (62) pour la production d'impulsions de tension (P, P2, P4, P20, P40), dans lequel les impulsions de tension présentent une longueur temporelle qui est inférieure à 40 ms, et un équipement de répartition de tension alternative (64), lequel répartit ces impulsions de tension (P, P2, P4, P20, P40) sur respectivement au moins une électrode du premier poste de revêtement (2) et du deuxième poste de revêtement (4), dans lequel l'équipement de répartition de tension alternative est adapté pour et destiné à répartir les impulsions de tension (P, P2, P4, P20, P40) sur les électrodes de façon décalée dans le temps, dans lequel le dispositif présente un équipement de transport, lequel transporte les récipients et/ou les postes de revêtement le long d'un trajet de transport prédéfini.

2. Dispositif (1) selon la revendication 1,
dans lequel
l'équipement de répartition de tension alternative (64) est réalisé en tant que multiplexeur.

3. Dispositif (1) selon au moins l'une des revendications précédentes, dans lequel
le dispositif (1) présente un équipement de transport mobile et en particulier rotatif, sur lequel les postes de revêtement (2, 4) sont disposés.

4. Dispositif (1) selon au moins l'une des revendications précédentes,
dans lequel
les postes de revêtement (2, 4) sont disposés de manière fixe.

5. Dispositif (1) selon au moins l'une des revendications précédentes,
dans lequel
le dispositif présente un équipement d'amenée de milieu (32, 34, 36), lequel est adapté pour et destiné à amener un milieu coulant et en particulier gazeux au récipient.

6. Dispositif (1) selon au moins l'une des revendications précédentes,
dans lequel
l'équipement de générateur haute fréquence délivre la tension sous forme d'impulsions de tension (P, P2, P4, P20, P40).

7. Dispositif (1) selon la revendication précédente,
dans lequel
l'équipement de répartition de tension alternative répartit les impulsions délivrées par l'équipement de générateur haute fréquence respectivement intégralement sur les électrodes individuelles.

8. Dispositif (1) selon au moins l'une des revendications précédentes,
dans lequel
la puissance pouvant être injectée de l'équipement de générateur haute fréquence peut être adaptée sur la base d'une valeur de mesure de la puissance réfléchie.

9. Dispositif (1) selon la revendication précédente,
dans lequel
il comprend un équipement de commande avec un équipement de mémoire, au moyen duquel une valeur de consigne prédéfinie pour un processus de revêtement suivant peut être comparée à au moins une valeur de mesure d'un processus de revêtement précédent, dans lequel de préférence au moins une valeur de mesure est une valeur de mesure d'un paramètre qui est choisi dans un groupe, lequel comprend une puissance réfléchie, une puissance introduite, une différence entre une puissance introduite et une puissance réfléchie, la puissance injectée dans le plasma, une émission optique du plasma, un débit volumétrique de gaz, une composition de gaz, une température de la lance à gaz et une température d'une surface de récipient seuls ou en combinaison.

10. Dispositif (1) selon la revendication précédente,
dans lequel
il comprend un équipement d'évaluation, par lequel un facteur peut être déterminé, avec lequel un paramètre est intégré dans le calcul pour la détermination d'une puissance à injecter, dans lequel de préférence le facteur est variable de manière dynamique.

11. Dispositif (1) selon la revendication précédente,
dans lequel
l'équipement d'évaluation est un système IA pour la reconnaissance de motifs et pour l'adaptation du facteur sur la base de celle-ci.

12. Procédé pour le revêtement d'objets (10) et en particulier de récipients (10) avec au moins un premier et un deuxième poste de revêtement (2, 4), dans lequel ces postes de revêtement (2, 4) présentent respectivement au moins une première électrode de revêtement (22, 42) et une deuxième électrode de revêtement (24, 44) et dans lequel respectivement au moins l'une des électrodes de revêtement (22, 24) est alimentée en énergie électrique avec un équipement d'alimentation (6), dans lequel
l'équipement d'alimentation (6) fournit des impulsions de tension (P, P2, P4, P20, P40) au moyen d'un équipement de générateur haute fréquence (62), dans lequel les impulsions de tension présentent une longueur temporelle qui est inférieure à 40 ms, et un équipement de répartition de tension alternative (64) répartit ces impulsions de tension (P, P2, P4, P20, P40) sur respectivement au moins une électrode du premier poste de revêtement (2) et au moins une électrode du deuxième poste de revêtement (4), dans lequel l'équipement de répartition de tension alternative répartit les impulsions de tension (P, P2, P4, P20, P40) sur les électrodes de façon décalée dans le temps, dans lequel le dispositif présente un équipement de transport, lequel transporte les récipients et/ou les postes de revêtement le long d'un trajet de transport prédéfini.

13. Procédé selon la revendication 12,
dans lequel
l'équipement de générateur haute fréquence (62) délivre la tension alternative sous forme d'impulsions de tension.

14. Procédé selon la revendication précédente,
dans lequel
un équipement de commande commande l'équipement de générateur haute fréquence (62) de telle sorte que les impulsions de tension sont délivrées par intervalles de temps prédéfinis.

15. Procédé selon au moins l'une des revendications précédentes 12-14, dans lequel
l'équipement de répartition de tension alternative répartit les impulsions de tension de telle sorte qu'à un moment prédéfini pas plus d'un poste de revêtement (2, 4) est alimenté en tension.
